(19) Europäisches Patentamt
European Patent Office
Office européen des brevets

(11) **EP 1 471 647 B1**

(12) **FASCICULE DE BREVET EUROPEEN**

(45) Date de publication et mention
de la délivrance du brevet:
**23.05.2007 Bulletin 2007/21**

(51) Int Cl.:
*H03M 13/39* *(2006.01)*   *H03M 13/29* *(2006.01)*
*H03M 13/05* *(2006.01)*   *H03M 13/23* *(2006.01)*

(21) Numéro de dépôt: **04364025.9**

(22) Date de dépôt: **30.03.2004**

(54) **Codage et décodage utilisant un code construit sur un treillis dont les sections sont basées sur des codes en bloc à bonne distance**

Codierung und Decodierung von Trellis-Codes mit Trellis Sektionen basierend auf Blockcodes mit guten Distanzeigenschaften

Encoding and decoding of trellis codes comprising trellis sections constructed on block codes with good distance.

(84) Etats contractants désignés:
**AT BE BG CH CY CZ DE DK EE ES FI FR GB GR HU IE IT LI LU MC NL PL PT RO SE SI SK TR**

(30) Priorité: **31.03.2003 FR 0303989**

(43) Date de publication de la demande:
**27.10.2004 Bulletin 2004/44**

(73) Titulaire: **FRANCE TELECOM**
**75015 Paris (FR)**

(72) Inventeurs:
- **Cadic, Emmanuel**
  **78500 Sartrouville (FR)**
- **Carlac'h, Jean-Claude**
  **35000 Rennes (FR)**

(74) Mandataire: **Vidon, Patrice**
**Cabinet Vidon**
**16 B, rue Jouanet - B.P. 90333**
**Technopole Atalante**
**35703 Rennes Cedex 7 (FR)**

(56) Documents cités:
**US-A- 4 295 218**

- **HAGENAUER J: "RATE-COMPATIBLE PUNCTURED CONVOLUTIONAL CODES (RCPC CODES) AND THEIR APPLICATIONS" IEEE TRANSACTIONS ON COMMUNICATIONS, IEEE INC. NEW YORK, US, vol. 36, no. 4, 1 avril 1988 (1988-04-01), pages 389-400, XP000670428 ISSN: 0090-6778**

**Description**

Le domaine de l'invention est celui des communications numériques. Plus précisément, l'invention concerne les codes correcteurs d'erreurs. L'invention concerne notamment, mais non exclusivement, les codes connus sous le nom de « turbo-code ».

L'invention peut trouver des applications dans tous les domaines où il est nécessaire, ou tout du moins souhaitable, de disposer d'un code correcteur d'erreur. Ainsi, l'invention peut par exemple s'appliquer :

- à la protection contre des erreurs dues aux bruits et interférences inhérents aux canaux physiques de transmissions (codage correcteur d'erreurs classiques et codes spatio-temporels pour les systèmes multi-antennes);
- la compression de signaux issus de sources d'informations : images, sons, signaux, données;
- la protection contre les erreurs pour le stockage des données sur des mémoires de masse, telles que les disques d'ordinateurs ou les micro-processeurs.

De nombreuses techniques de codage permettant la correction d'erreurs sont déjà connues. Les premières études sur le sujet remontent aux années 1940. C'est à cette époque que Shannon a fondé la théorie de l'information actuellement encore utilisée. De nombreuses familles de codage ont ensuite été proposées.

On connait ainsi les codes convolutifs (qui peuvent notamment mettre en oeuvre des codages en treillis, selon l'algorithme Viterbi), ou encore le schéma de codage couramment désigné sous le terme « turbo-code », proposé en 1993 par C. Berrou et A. Glavieux, par exemple dans l'article « Near Shannon Limit Error-Correcting Coding and Decoding : Turbo-Codes » (proofreadings of the ICC'93, mai 1993, p.1064 à 1070).

Cette technique a fait l'objet de nombreuses études et améliorations.

On connaît également la famille de codes connue sous le nom de codes LDPC.

Les turbo-codes et les codes LDPC, et plus généralement tous les codes concaténés, offrent des performances en termes de correction qui sont remarquables, pour de grandes tailles de blocs, et notamment des blocs d'au moins quelques milliers ou dizaines de milliers de bits d'information.

Malheureusement, la manipulation de tels blocs de bits d'informations présente une forte complexité de calcul au décodage, qui ne s'avère en pratique compatible qu'avec des micro-processeurs à grosse capacité de calcul qui s'avèrent en conséquence relativement coûteux.

De plus, ces structures sont en revanche peu performantes en correction d'erreurs pour des blocs de petites tailles, par exemple de l'ordre de la centaine ou du millier de bits.

On connait par ailleurs une technique de construction de codes correcteurs d'erreurs à partir d'un ou plusieurs sous-codes et d'un graphe associé, telle qu'exposée dans le brevet US 4,295,218. Cette approche permet notamment de fournir des codes simples à mettre en oeuvre et très efficaces pour la construction de codes de grandes longueurs.

Il existe cependant actuellement dans le domaine des transmissions numériques une très forte demande pour les communications par petits paquets, ce qui suppose la mise en oeuvre de codes de petites longueurs.

L'invention a notamment pour objectif d'apporter une solution à ce besoin et de pallier les inconvénients des techniques antérieures.

Plus précisément, un objectif de l'invention est de fournir une technique de codage correcteur d'erreurs, notamment du type « turbo-code », permettant de réduire la complexité du décodage.

En d'autres termes, l'invention a pour objectif de fournir une telle technique de codage, qui permette la réalisation de décodeur simplifié, et donc à coût réduit, sans bien sûr dégrader la qualité de la correction des erreurs.

Un autre objectif de l'invention est de fournir une telle technique de codage, qui soit bien adaptée à la correction d'erreur pour des blocs de petites tailles.

En d'autres termes, un autre objectif de l'invention est de fournir une telle technique, offrant de bonnes distances minimales, malgré de petites tailles de blocs.

Encore un autre objectif de l'invention est de fournir une telle technique, qui permette de réaliser le codage et le décodage de façon simple, et pouvant en conséquence être aisément implanté.

Ces objectifs, ainsi que d'autres qui apparaîtront plus clairement par la suite, sont atteints à l'aide d'un procédé de codage correcteur d'erreur, selon la revendication 1.

Un code ainsi constitué est très simple, puisqu'il est formé à partir de briques de base de très faibles taille et complexité (qui peuvent le cas échéant être réalisées en analogique, de façon câblée), et cependant très efficace. Comme on le verra par la suite, il permet notamment de reproduire des codes connus en soi, mais sous une forme très simplifiée.

Plus précisément, l'invention permet d'obtenir une diminution de la complexité d'un rapport au moins 2 (notamment par l'utilisation de treillis à faible nombre d'états, en l'occurrence un minimum de 4 pour les codes binaires, comme expliqué par la suite) par rapport à l'état de l'art existant pour une même capacité de correction.

En outre, ces codes binaires de petites longueurs construits avec ces treillis peuvent avoir de très bonnes distances minimales, d'où une capacité à corriger plus d'erreurs que les « turbo-codes » actuels malgré de petites tailles de bloc et des treillis avec seulement 4 états dans le cas binaire.

De façon préférentielle, les mots de code dudit code élémentaire ont subi un partitionnement en quatre paquets (s0, s1), (s2, s3), (b0, b1), (b2, b3) tel que chaque mot de code, à l'exception du mot de code nul, comprend au moins trois paquets sur quatre allumés, un paquet étant dit allumé lorsqu'il comprend au moins un bit valant 1.

Cela permet la propagation de « 1 », et ainsi d'augmenter la distance du code.

Avantageusement, lesdites sections de code élémentaire sont associées en séquence de façon à former au moins un treillis de codage. Un choix judicieux des séquences d'étages (sections) formant ce treillis permet d'optimiser la capacité de correction d'erreurs.

Selon un mode de réalisation avantageux, le ou lesdits treillis sont cycliques.

Cela permet d'optimiser les capacités de correction et d'uniformiser le niveau de protection entre les bits d'information.

Dans ce cas, on conserve avantageusement comme résultat de codage celui qui présente un état d'arrivée identique à son état d'arrivée, parmi tous les états de départ possible pour l'une desdites sections de code élémentaire, choisie comme section de départ.

De façon avantageuse, le procédé de codage de l'invention comprend deux treillis, dans lesquels les données source à coder sont entrées dans des ordres différents.

Selon un mode de réalisation préférentiel, ledit résultat de codage est l'ensemble des éléments d'information et de redondance délivrés par le ou lesdits treillis.

On peut avantageusement appliquer un poinçonnage sur lesdits éléments formant le résultat de codage.

De même, selon un aspect particulier de l'invention, on peut prévoir qu'au moins une desdites sections est poinçonnée. Préférentiellement, on utilise au moins une section poinçonnée à gauche et au moins une section poinçonnée à droite.

Selon un mode de réalisation préférentiel de l'invention, on duplique au moins une fois le ou lesdits treillis, pour disposer d'au moins deux ensembles de codage interconnectés via des moyens de permutation.

Dans ce cas, les données à coder peuvent avantageusement être transmises à chacun desdits ensembles de codage, préférentiellement de façon décalée.

Selon une première approche de l'invention, lesdits vecteurs sont constitués d'éléments binaires. Dans ce cas, ledit code élémentaire est avantageusement un code de Hamming [8, 4, 4].

Le procédé de codage peut dans ce cas mettre en oeuvre les sections suivantes $H_\alpha$ à $H_\phi$, d'entrée $(x_0, x_1)$ et de sortie $(y_0, y_1)$:

- $H_\alpha : (y_0, y_1, x_0, x_1) \rightarrow (b_0, b_1, b_2, b_3)$
- $H_\beta : (x_0, x_1, y_0, y_1) \rightarrow (b_0, b_1, b_2, b_3)$
- $H_\gamma : (x_0, y_0, y_1, x_1) \rightarrow (b_0, b_1, b_2, b_3)$
- $H_\delta : (y_0, x_0, x_1, y_1) \rightarrow (b_0, b_1, b_2, b_3)$
- $H_\varepsilon : (y_0, x_0, y_1, x_1) \rightarrow (b_0, b_1, b_2, b_3)$
- $H_\phi : (x_0, y_0, x_1, y_1) \rightarrow (b_0, b_1, b_2, b_3)$

Avantageusement, il utilise en outre les sections poinçonnées suivantes :

- $H^g : (*, *, x_0, x_1) \rightarrow (*, *, b_2, b_3)$
- $H^d : (x_0, x_1, *, *) \rightarrow (b_0, b_1, *, *)$

Selon un mode de réalisation particulier, le codage comprend trois ensembles de codage recevant chacun 12 bits de codage via respectivement une permutation identité, une permutation à décalage cyclique de 4 bits et une permutation à décalage cyclique de 4 bits.

Dans ce cas, lesdits ensembles de codage sont avantageusement organisés de façon à produire un code de Golay [24, 12, 8].

Selon une autre approche avantageuse, lesdits vecteurs sont constitués de mots de base pouvant prendre 4 valeurs. Dans ce cas, ledit code élémentaire est avantageusement un code de Nordstrom-Robinson de paramètres [8, 4, 6].

Selon encore une autre approche avantageuse de l'invention, lesdits vecteurs sont constitués de mots de base pouvant prendre 8 valeurs. Alors, ledit code élémentaire peut notamment être un code N16.

Selon un aspect préférentiel de l'invention, le code ainsi obtenu est du type « turbo-code ».

L'invention concerne également les dispositifs de codage correcteur d'erreur mettant en oeuvre un tel procédé de codage.

L'invention concerne encore les dispositifs et procédés de décodage correspondants.

Un tel procédé met en oeuvre des étapes symétriques de celles mises en oeuvre au codage. Ainsi, on utilise au moins deux sections distinctes d'un code élémentaire prédéterminé, associant à un vecteur d'état de départ (s0, s1) un vecteur d'arrivée (s2, s3), en fonction d'un vecteur d'étiquettes de branches (b0, b1, b2, b3), deux sections dudit code élémentaire étant distinctes lorsque l'ordre et/ou le rôle des éléments dudit vecteur d'étiquettes de branches sont modifiées.

De façon préférentielle ledit procédé de décodage est itératif.

Avantageusement, à chacune des itérations, on calcule des probabilités a posteriori sur des métriques associés à au moins un treillis défini à l'aide desdites sections de code élémentaire, et on interrompt lesdites itérations lorsqu'on obtient un résultat stable et/ou après un nombre prédéterminé d'itérations.

D'autres caractéristiques et avantages de l'invention apparaîtront à la lecture de la description suivante de modes de réalisations de l'invention, donnés à titre de simples exemples illustratifs et non limitatifs, et des figures annexées parmi lesquelles:

- la figure 1 présente la section de base d'un code élémentaire utilisé selon un premier mode de réalisation de l'invention, et le graphe de Tanner correspondant ;
- la figure 2 est un exemple de turbo-code parallèle construit à l'aide de la section selon la figure 1 ;
- la figure 3 est un autre exemple de treillis construit à l'aide de la section de la figure 1;
- la figure 4 présente un turbo-code parallèle à trois permutations utilisant un code selon le treillis de la figure 3;
- les figures 5a à 5e sont des courbes de taux d'erreurs binaires pour différents types de codes et différents nombres d'itérations;
- la figure 6 est une comparaison des résultats de décodage de la technique de l'invention avec trois autres techniques de l'art antérieur;
- la figure 7 est un graphe de Tanner pour un code à section de base à 16 états;
- la figure 8 présente un graphe de Tanner pour un code à section de base à 64 états.

## 1) Principes généraux de l'invention :

Comme déjà mentionné, l'objectif de l'invention est de fournir des codes, notamment des « turbo-codes », dont la complexité de décodage est moindre, par rapport aux techniques connues, tout en garantissant de bonnes capacités de correction d'erreurs, même pour de petites tailles de blocs.

Comme on le verra par la suite l'invention permet d'obtenir une diminution de la complexité d'un rapport au moins égal à 2, notamment en utilisant des treillis à faible nombre d'états (en l'occurrence un minimum de 4 états pour les codes binaires) par rapport aux techniques connues, pour une même capacité de correction.

Par ailleurs, les codes de petites longueurs construits avec ces treillis ont de très bonnes distances minimales, d'où une capacité à corriger plus d'erreurs que les « turbo-codes » actuels, malgré cette petite taille de blocs et des treillis.

Dans le cas des codes binaires, un élément technique important de l'invention est l'utilisation d'étages de treillis à 4 états dérivés d'une section de base. Dans le mode de réalisation décrit par la suite (paragraphe 2) cette section est appelée "H", et représente le code de Hamming étendu, de paramètres [8,4,4].

La simplicité et la performance des turbo-codes obtenus selon l'invention découle du fait que ce petit code est unique, et qu'il présente une longueur de 8 bits, pour 4 bits d'information utile, et une distance minimale entre les mots de codes égale à 4.

Les sections, ou étages, de treillis sont dérivées de la section de base, en changeant l'ordre et le rôle (entrée ou sortie) des bits d'étiquettes de branches.

Un autre aspect important est que les petits codes de base pris pour construire les étages de base sont partitionnés, selon une approche non triviale, en 4 paquets de bits, la partition étant telle que tout les mots de codes non nuls ont toujours au moins 3 paquets sur 4 non nuls, c'est-à-dire qu'il ont au moins 1 bit non nul par paquet. On dit par la suite que l'on a toujours au moins 3 paquets sur 4 "allumés", un paquet étant allumé lorsqu'au moins 1 bit est non nul.

Dans le cas cité précédemment du code de Hamming {8,4,4}, les quatre paquets sont composés de 2 bits.

Selon l'invention, chaque treillis est donc vu comme une séquence d'étages différents (ou non) dérivés d'une section de base. Un choix judicieux de ces séquences permet d'optimiser la capacité de correction d'erreurs.

De façon préférentielle, les treillis ainsi obtenus sont cycliques (ou "tail-biting" en anglais), ce qui permet d'optimiser les capacités de corrections d'erreurs, et d'uniformiser le niveau de protection entre les bits d'informations.

Pour les codes sur l'anneau Z4 (qui est l'ensemble {0,1,2,3} muni de l'addition et de la multiplication modulo 4), on peut notamment utiliser un code équivalent ou code Nordstrom-Robinson de paramètres {8,4,6}, avec la distance de Lee (voir paragraphe 3).

On obtient alors des treillis à 16 états.

De même, on peut réaliser des codes sur Z8 et Z16, en utilisant deux autres petits codes performants, pour obtenir respectivement des étages à 64 et 256 états (voir paragraphe 4).

Ces codes sur Z4 (respectivement Z8) peuvent notamment permettre de construire des modulations codées MDP4 (modulation de phase à 4 points), (respectivement MDP8, MDP16 ou MAQ16(modulation d'amplitude en quadrature à 16 points)) extrêmement performante.

Sur Z4, on peut ainsi, avec une faible complexité, s'étendre à des modulations codées MDP16 ou MAQ16. De même, dans l'ensemble Z8 on pourra s'étendre à une modulation MAQ64.

En effet, on peut décomposer une modulation MDP4 en deux modulations MDP2, ou une modulation MAQ16 en deux modulations MDP4, une modulation MAQ32 en un produit d'une modulation MAQ8 et d'une modulation MDP4, une modulation MAQ64 en deux modulations MDP8, ou encore une modulation MAQ256 en deux modulations MDP16...

Les treillis réalisés sur Z4 ou Z8 sont donc de bonnes briques de bases, de faible complexité, pour construire à coût réduit des modulateurs-codeurs de très grandes performances, et se décodant plus facilement.

**2) Sections de base à 4 états pour « turbo-codes » binaires**

a) sections de treillis de base non-poinçonnées à 4 états pour « turbo-codes » binaires

La section « H » de treillis de base décrit les mots du code de Hamming[8,4,4] qui a pour matrice génératrice $G_H$ telle que :

$$G_H = \begin{bmatrix} I_4 & P \end{bmatrix} = \begin{bmatrix} 1 & 0 & 0 & 0 & 0 & 1 & 1 & 1 \\ 0 & 1 & 0 & 0 & 1 & 1 & 0 & 1 \\ 0 & 0 & 1 & 0 & 1 & 0 & 1 & 1 \\ 0 & 0 & 0 & 1 & 1 & 1 & 1 & 0 \end{bmatrix}$$

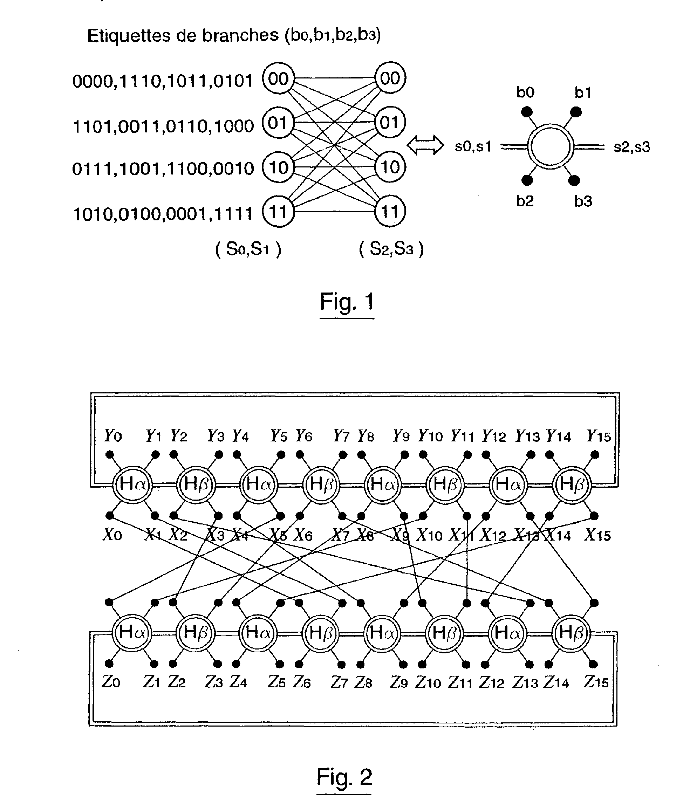

La section H, illustrée par la figure 1, représente l'ensemble des mots de code du code de Hamming[8,4,4] sous la forme d'un ensemble de chemins des états de départ ($s_0$, $s_1$ ) vers les états d'arrivée ($s_2$,$s_3$) en passant par les branches d'étiquettes $(b_0, b_1, b_2, b_3)$.

Les vecteurs d'état et d'étiquettes sont reliés par l'équation matricielle: $(s_0, s_1, s_2, s_3) = (b_0, b_1, b_2, b_3) \cdot P$.

Les étiquettes sont énumérées de façon classique : en face de chaque état de départ et dans l'ordre 00,01,10,11 des états d'arrivée associés. A droite de la section est représenté le graphe de Tanner de cette section.

Le code de Hamming[8,4,4] est partitionné en 4 paquets $(s_0, s_1), (s_2, s_3)$ , $(b_0, b_1)$ et $(b_2, b_3)$ avec la distribution de paquets de 2 bits « allumés » suivante :

- 1 mot avec 0 paquet sur 4 allumé (le mot nul),
- 12 mots avec 3 paquets sur 4 allumés soit 75% des mots du code,
- 3 mots avec 4 paquets sur 4 allumés soit 18.75% des mots du code.

Cette propriété locale de « (au moins) 3 paquets sur 4 allumés » permet d'imposer que, globalement, le graphe de Tanner du code concaténé ne puisse contenir des sous-graphes d'états non-nuls de taille trop petite, et donc d'obtenir de bonnes distances minimales.

Les 6 sections non-poinçonnées dérivées de la section $H$ sont appelées $H_\alpha$ , $H_\beta$ , $H_\delta$ , $H_\gamma$ , $H_\varepsilon$ , $H_\phi$ et leurs bits d'information $(x_0 , x_1)$ et de redondance $(y_0, y_1)$ correspondent respectivement aux bits $(b_0, b_1, b_2, b_3)$ tels que:

- $H_\alpha : (y_0, y_1, x_0, x_1) \rightarrow (b_0, b_1, b_2 b_3)$
- $H_\beta : (x_0, x_1, y_0, y_1) \rightarrow (b_0, b_1, b_2, b_3)$
- $H_\gamma : (x_0, y_0, y_1, x_1) \rightarrow (b_0, b_1, b_2, b_3)$
- $H_\delta : (y_0, x_0, x_1, y_1) \rightarrow (b_0, b_1, b_2, b_3)$
- $H_\varepsilon : (y_0, x_0, y_1, x_1) \rightarrow (b_0, b_1, b_2 \cdot b_3)$
- $H_\phi : (x_0, y_0, x_1, y_1) \rightarrow (b_0, b_1, b_2, b_3)$

Le fait d'utiliser un bit d'étiquette soit comme une entrée (bit d'information) ou une sortie (bit de redondance) dans la section H change complètement la fonction booléenne. On obtient ainsi une grande variété de choix de treillis (et donc de codes), un treillis correspondant une séquence de sections, comme illustré par la figure 2.

La figure 2 donne en effet un exemple de « turbo-code » parallèle à 1 permutation comprenant deux treillis cycliques « tail-biting » construits avec les sections listées ci-dessus.

b) sections de treillis de base poinçonnées à 4 états pour « turbo-codes » binaires

On peut utiliser des sections de base poinçonnées.

Les sections de base poinçonnées sont également construites en partant de la section de base $H$ en poinçonnant par exemple deux bits à gauche ou à droite sur toutes les sections non-poinçonnées précédentes et sont notées $H^g$ et $H^d$ pour la section de base :

- $H^g : (*, *, x_0, x_1) \rightarrow (*, *, b_2, b_3)$
- $H^d : (x_0, x_1, *, *) \rightarrow (b_0, b_1, *, *)$

Les bits poinçonnés (enlevés) sont indiqués par des étoiles *. On note $H_a^g$ et $H_a^d$ avec $a \in \{\alpha, \beta, \gamma, \delta, \varepsilon, \phi\}$ les autres sections dérivées et poinçonnées écrites précédemment.

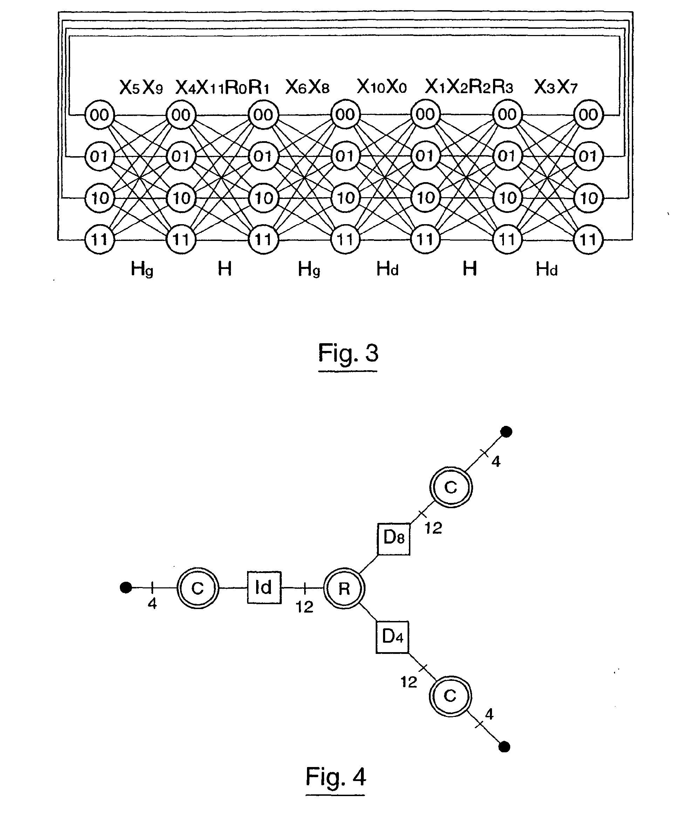

La figure 3 présente un exemple de treillis cyclique utilisant de telles sections, et correspondant au code de paramètres C[16,12,2]. Il est composé de la séquence $(H^g, H, H^g, H^d, H, H^d)$ sur lequel on a fait correspondre les 12 bits d'informations Xi , (i=0,1,... 11) et les 4 bits de redondance Rj (j=0,1,...,3) du code de paramètres C[16,12,2].

La figure 4 ci-dessous montre un exemple d'utilisation (triple) du treillis de la figure 3, et donc du code C[16,12,2] précédent par la mise en parallèle de 3 treillis recevant chacun les 12 bits d'information placés au centre de l'étoile.

Le bloc R représente le code à répétition triple du vecteur d'information de 12 bits.

Les permutations dans ce cas particulier sont très simples : il s'agit de la permutation identité notée Id correspondant à la séquence (X5,X9,X4,X11,X6,X8,X10,X0,X1,X2,X3,X7), et des permutations décalage cyclique respectivement de 4 bits et 8 bits notées $D_4$ et $D_8$ délivrant des séquences décalées circulairement de 4 places et 8 places par rapport à la séquence de l'identité.

Les « turbo-codes » pouvant être construits avec de tels séquences et de tels treillis composants sont très divers : « turbo-codes » série, « turbo-codes » parallèle, « turbo-codes » hybrides série-parallèle, codes « Repeat-Accumulate » ,...

c) Description du codage de ces « turbo-codes »

Les données d'entrée pour effectuer le codage sur l'exemple de la figure 2 sont les bits d'information $(x_0, x_1, ..., x_{15})$ à partir desquels on calcule les bits de redondance $(y_0, y_1, ..., y_{15})$ et $(z_0, z_1, ..., z_{15})$. Les bits d'information placés dans ce cas au milieu de la structure sont entrés dans l'ordre naturel sur l'un des treillis et permutés dans l'autre.

Comme il y a peu (4, 8,ou 16) d'états de départ pour chaque treillis cyclique, une façon simple de coder est de choisir arbitrairement une section comme section de départ et de calculer et mémoriser les bits de redondance y et l'état d'arrivée (s2,s3) pour les bits d'étiquettes x et pour chaque état de départ possible (s0,s1).

Par exemple, pour chacun des 4 états de départ {00, 01,10,11} et les 2 bits d'information $(x_0, x_1)$ de la section de départ, on calcule (on lit) l'état suivant en se servant de la section de treillis comme d'une table logique.

On recommence pour la section suivante jusqu'à retourner à l'entrée de la section de départ puisque le treillis est cyclique (« tail-biting » en anglais) : un mot de code est un circuit simple constitué d'une branche dans chaque section du treillis et ayant donc le, même état de départ et d'arrivée.

On ne garde donc que le résultat de codage qui a son état d'arrivée égal à son état de départ. Le résultat du codage est l'ensemble des bits d'information et de redondance, que l'on peut choisir de transmettre ou non selon u éventuel poinçonnage avant émission.

On peut bien sûr, avec l'algorithme décrit précédemment, calculer une fois pour toute la matrice génératrice du code et l'utiliser pour faire le codage par multiplication vecteur-matrice, mais cela sera plus coûteux en quantité de calcul.

d) Description du décodage itératif de ces « turbo-codes »

Le décodage « soft » itératif peut s'appuyer sur celui, maintenant classique, des « turbo-codes ». A partir des informations a priori disponibles sur les bits d'information et de redondance à la réception en sortie du démodulateur.

Ces bits sont représentés par des points noirs dans le graphe de Tanner comme celui de la figure 2. Sur chaque treillis, on calcule les probabilités a posteriori à partir des probabilités a priori disponibles selon l'algorithme BCJR, ou une de ses variantes, avec des métriques (SISO, SOVA, SUBMAP...), pour en extraire des informations dites « extrinsèques », que l'on injectent dans le ou les autres treillis. On itère ce processus jusqu'à stabilité ou un nombre fixe d'itérations.

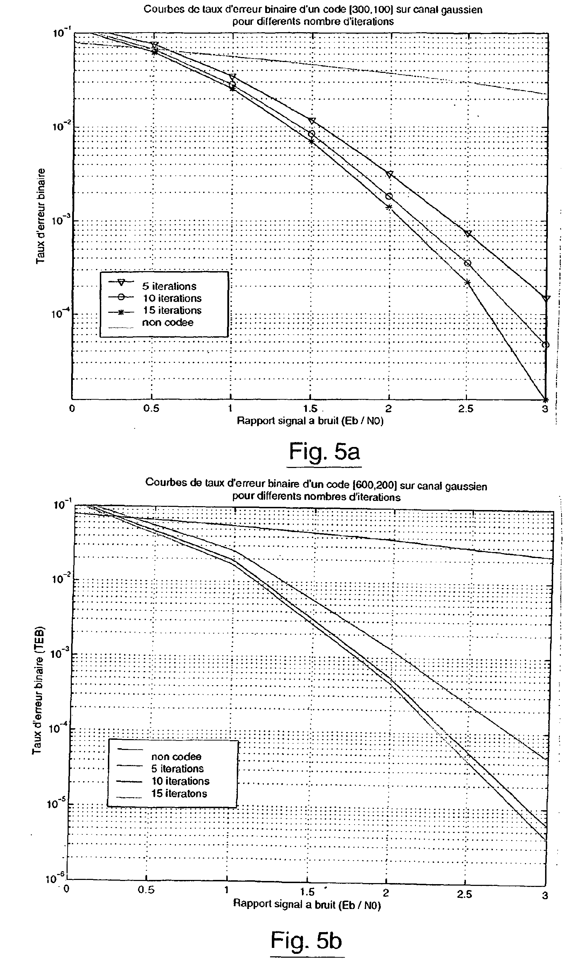

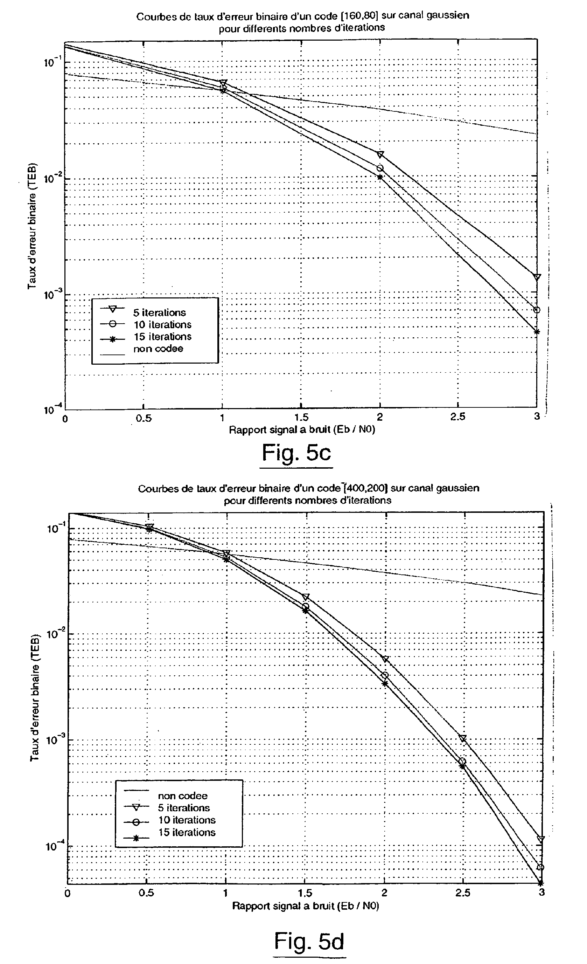

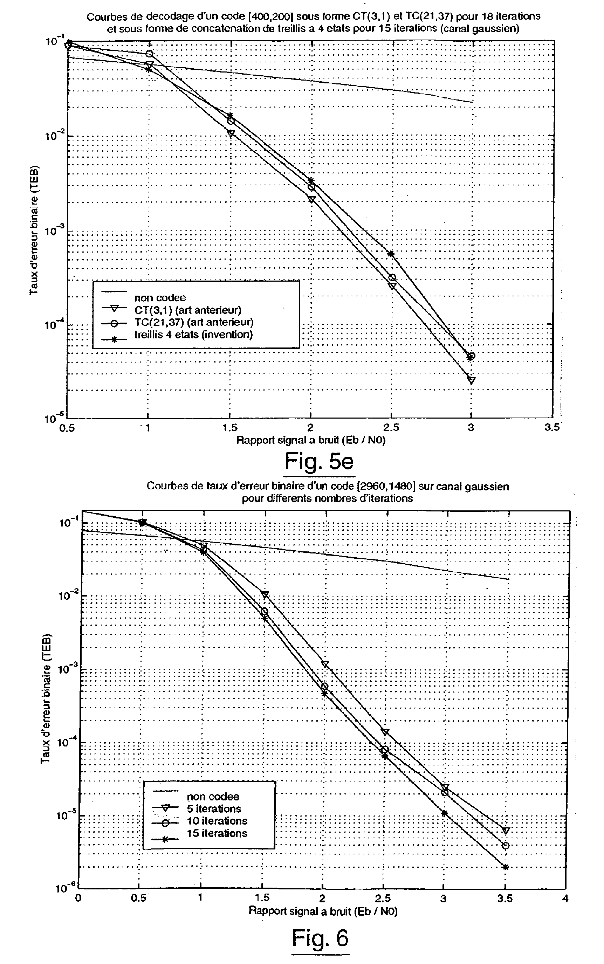

Les figures 5a à 5e présentent quelques courbes de taux d'erreurs binaires (TEB en fonction du rapport signal/bruit utile Eb/N0) résultant de cet algorithme, pour quelques codes de longueurs et de rendement 1/2 et 1/3 simulés sur canal gaussien et modulation de phase à 2 états « MDP2 ».

La figure 6 est une courbe de comparaison en terme de TEB de codes de longueur 400 codant 200 bits d'informations utiles selon l'art antérieur avec des treillis à 16 états (ou une complexité équivalente) et de premiers résultats (non encore optimisés) d'un code selon l'invention pour ces longueurs.

Pour une complexité environ 2 fois moindre, on constate que l'on a déjà des performances comparables, sans optimiser les permutations et les structures.

Les courbes notées respectivement CT(3,1) et TC(21,37) correspondent respectivement aux « turbo-codes » antérieurs de Li-Ping construits avec 3 codes en arbre et aux « turbo-codes » de Berrou avec treillis binaires à 16 états.

On constate que les « turbo-codes » à 4 états construits selon l'invention deviennent meilleurs pour des Eb/N0 nettement supérieurs à 3.5dB (en dehors de la courbe).

Ces nouveaux « turbo-codes » n'ont pourtant pas encore été optimisés selon leurs permutations et leurs structures alors que ceux de l'art antérieur l'ont été longuement.

Dans l'exemple présenté, la structure des nouveaux treillis utilisée est en effet non optimisée et invariante, car composée uniquement de sections $H_\alpha$. Une diversité de types de sections dans chaque treillis permettra d'augmenter les capacités de correction et donc d'améliorer les courbes de TEB.

### 3) Sections de base à 16 états pour turbo-codes sur $Z_4$

La section « N » de treillis de base « sur $Z_4$» décrit l'ensemble des mots du code ayant ses symboles pris dans l'anneau des entiers modulo 4 , $Z_4$ = {0,1,2,3}, équivalent au code de Nordstrom-Robinson de paramètres N[8,4,6] ayant pour matrice génératrice $G_N$ telle que :

$$G_N = \begin{bmatrix} 1_4 & P_N \end{bmatrix} = \begin{bmatrix} 1 & 0 & 0 & 0 & 2 & 1 & 1 & 1 \\ 0 & 1 & 0 & 0 & 3 & 3 & 2 & 1 \\ 0 & 0 & 1 & 0 & 3 & 1 & 3 & 2 \\ 0 & 0 & 0 & 1 & 3 & 2 & 1 & 3 \end{bmatrix}$$

Les 4 symboles {0,1,2,3} de $Z_4$ correspondent au mapping de Gray sur 2 bits suivant :

$$0 \leftrightarrow \{0,0\}, 1 \leftrightarrow \{0,1\}, 2 \leftrightarrow \{1,1\}, 3 \leftrightarrow \{1,0\},$$

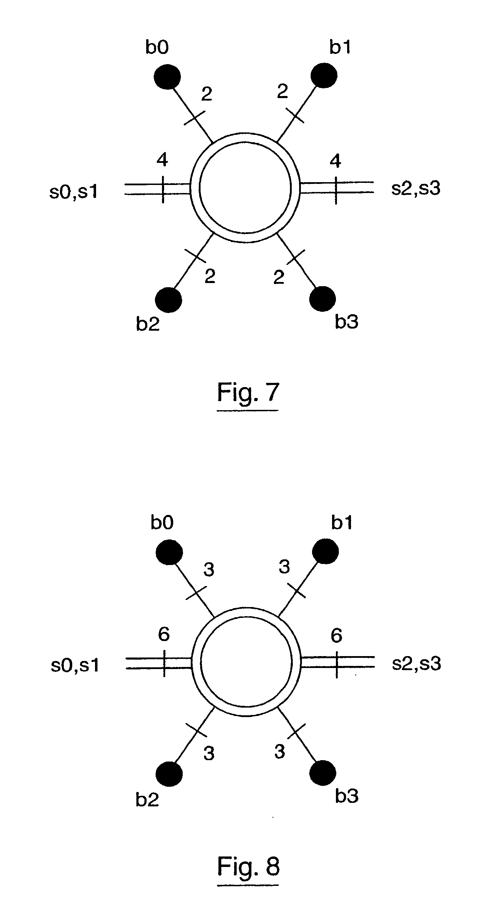

La section N, illustrée de façon simplifiée sur la figure 7 par son graphe de Tanner, représente l'ensemble des mots de code du code de N[8,4,6] par un ensemble de chemins des états de départ ($s_0,s_1$) vers les états d'arrivée ($s_2$, $s_3$) en passant par les branches d'étiquettes ($b_0,b_1,b_2,b_3$). Les vecteurs d'état et d'étiquettes sont reliés par l'équation matricielle : ($s_0,s_1,s_2,s_3$) = ($b_0,b_1,b_2,b_3$) · $P_N$.

Le code de N[8,4,6] partitionné en 4 paquets de 2 symboles sur $Z_4$, ($s_0,s_1$), ($s_2,s_3$), ($b_0,b_1$) et ($b_2$ , $b_3$ ) a la distribution de paquets de 2 symboles « allumés » suivante :

- 1 mot avec 0 paquet sur 4 allumé (le mot nul),
- 60 mots avec 3 paquets sur 4 allumés soit environ 23% des mots du code,
- 195 mots avec 4 paquets sur 4 allumés soit environ 76% des mots du code.

On remarque que la propriété « au moins 3 sur 4 » est encore plus accentuée avec le code N[8,4,6] sur $Z_4$ par rapport au code binaire de Hamming[8,4,4] . Il est donc tout à fait intéressant d'utiliser des treillis construits avec cette section de base à 16 états car les 2 symboles d'état sur $Z_4$ sont codés avec 2 bits chacun.

On peut utiliser les mêmes motifs de poinçonnage et d'ordonnancement des symboles sur les étiquettes du bloc de base pour obtenir toutes les sections dérivées comme pour les sections dérivées de la section H présentées précédemment.

### 4) Sections de base à 64 états pour turbo-codes sur $Z_8$

La section « M » de treillis de base « sur $Z_8$ » décrit l'ensemble des mots du code ayant ses symboles pris dans l'anneau des entiers modulo 8 , $Z_8 = \{0,1,...,7\}$, ayant pour matrice génératrice $G_M$ telle que :

$$G_M = \begin{bmatrix} 1_4 & P_M \end{bmatrix} = \begin{bmatrix} 1 & 0 & 0 & 0 & 1 & 5 & 7 & 4 \\ 0 & 1 & 0 & 0 & 4 & 1 & 5 & 7 \\ 0 & 0 & 1 & 0 & 7 & 4 & 1 & 5 \\ 0 & 0 & 0 & 1 & 5 & 7 & 4 & 1 \end{bmatrix}$$

Les symboles $\{0,1,...,7\}$ de $Z_8$ correspondent au codage binaire classique des entiers sur 3 bits :

$$0 \leftrightarrow \{0,0,0\}, 1 \leftrightarrow \{0,0,1\}, 2 \leftrightarrow \{0,1,0\}, 3 \leftrightarrow \{0,1,1\}, 4 \leftrightarrow \{1,0,0\}, 5 \leftrightarrow \{1,0,1\},$$
$$6 \leftrightarrow \{1,1,0\}, 7 \leftrightarrow \{1,1,1\},$$

La section M, illustrée de façon simplifiée sur la figure 8 par son graphe de Tanner, représente l'ensemble des mots de code du code de M[8,4] par un ensemble de chemins des états de départ $(s_0,s_1)$ vers les états d'arrivée $(s_2, s_3)$ en passant par les branches d'étiquettes $(b_0,b_1,b_2,b_3)$. Les vecteurs d'état et d'étiquettes sont reliés par l'équation matricielle: $(s_0,s_1,s_2,s_3) = (b_0,b_1,b_2,b_3) \cdot P_M$.

Le code de M[8,4] partitionné en 4 paquets de 2 symboles sur $Z_8$, $(s_0,s_1)$, $(s_2,s_3)$, $(b_0,b_1)$ et $(b_2,b_3)$, a la distribution de paquets de 2 symboles « allumés » suivante :

- 1 mot avec 0 paquet sur 4 allumé (le mot nul),
- 252 mots avec 3 paquets sur 4 allumés soit environ 6% des mots du code,
- 3443 mots avec 4 paquets sur 4 allumés soit environ 94% des mots du code.

On remarque que la propriété « au moins 3 sur 4 » est encore plus accentuée avec ce code M[8,4] sur $Z_8$ par rapport au code quaternaire N[8,4,6] et le code binaire de Hamming[8,4,4] .

On peut bien sûr trouver d'autres codes [8,4] qui ont cette même propriété « au moins 3 sur 4 » qui est essentielle lors de la concaténation des étages de treillis et l'utilisation de ces treillis pour construire efficacement de plus grands codes.

Il est donc tout à fait intéressant d'utiliser des treillis construits avec cette section de base à 64 états car les 2 symboles d'état sur $Z_8$ sont codés avec 3 bits chacun.

On pourra utiliser les mêmes motifs de poinçonnage et d'ordonnancement des symboles sur les étiquettes du bloc de base pour obtenir toutes les sections dérivées comme les sections dérivées des sections N et H présentées précédemment.

**Revendications**

1.  Procédé de codage correcteur d'erreur, **caractérisé en ce qu'**il met en oeuvre au moins deux sections distinctes d'un code élémentaire prédéterminé, associant à un vecteur d'état de départ (s0, s1) un vecteur d'état d'arrivée (s2, s3), en fonction d'un vecteur d'étiquettes de branches (b0, b1, b2, b3),
ledit vecteur d'état de départ, ledit vecteur d'état d'arrivée, et ledit vecteur d'étiquettes de branches définissant un mot de code élémentaire,
deux sections dudit code élémentaire étant distinctes si :

   - les ordres des éléments du vecteur d'étiquettes de branches, dans ledit mot de code élémentaire de chacune des deux sections, sont différents ; et/ou
   - les rôles, à savoir entrée ou sortie de ladite section, d'au moins un des éléments du vecteur d'étiquettes de branches, sont différents.

2.  Procédé de codage selon la revendication 1, **caractérisé en ce que** les mots de code dudit code élémentaire ont subi un partitionnement en quatre paquets (s0, s1), (s2, s3), (b0, b1), (b2, b3) tel que chaque mot de code, à l'exception du mot de code nul, comprend au moins trois paquets sur quatre allumés, un paquet étant dit allumé lorsqu'il comprend au moins un bit valant 1.

3. Procédé de codage selon l'une quelconque des revendications 1 et 2, **caractérisé en ce que** lesdites sections de code élémentaire sont associées en séquence de façon à former au moins un treillis de codage.

4. Procédé de codage selon la revendication 3, **caractérisé en ce que** le ou lesdits treillis sont cycliques.

5. Procédé de codage selon l'une quelconque des revendications 3 et 4, **caractérisé en ce qu'**il comprend deux treillis, dans lesquels les données source à coder sont entrées dans des ordres différents.

6. Procédé de codage selon l'une quelconque des revendications 4 et 5, **caractérisé en ce qu'**on conserve comme résultat de codage celui qui présente un état d'arrivée identique à son état de départ, parmi tous les états de départ possible pour l'une desdites sections de code élémentaire, choisie comme section de départ.

7. Procédé de codage selon la revendication 6, **caractérisé en ce que** ledit résultat de codage est l'ensemble des éléments d'information et de redondance délivrés par le ou lesdits treillis.

8. Procédé de codage selon la revendication 7, **caractérisé en ce qu'**il met en oeuvre un poinçonnage sur lesdits éléments formant le résultat de codage.

9. Procédé de codage selon l'une quelconque des revendications 1 à 8, **caractérisé en ce qu'**au moins une desdites sections est poinçonnée.

10. Procédé de codage selon la revendication 9, **caractérisé en ce qu'**il met en oeuvre au moins une section poinçonnée à gauche et au moins une section poinçonnée à droite.

11. Procédé de codage selon l'une quelconque des revendications 3 à 10, **caractérisé en ce que** le ou lesdits treillis sont dupliqués au moins une fois, pour disposer d'au moins deux ensembles de codage interconnectés via des moyens de permutation.

12. Procédé de codage selon la revendication 11, **caractérisé en ce que** les données à coder sont transmises à chacun desdits ensembles de codage de façon décalée.

13. Procédé de codage selon l'une quelconque des revendications 1 à 12, **caractérisé en ce que** lesdits vecteurs sont constitués d'éléments binaires.

14. Procédé de codage selon la revendication 13, **caractérisé en ce que** ledit code élémentaire est un code de Hamming [8, 4, 4].

15. Procédé de codage selon la revendication 14, **caractérisé en ce qu'**il met en oeuvre les sections suivantes $H_\alpha$ à $H_\phi$, d'entrée $(x_0,x_1)$ et de sortie $(y_0,y_1)$ :

- $H_\alpha : (y_0, y_1, x_0, x_1) \rightarrow (b_0,b_1,b_2,b_3)$
- $H_\beta : (x_0,x_1,y_0,y_1) \rightarrow (b_0,b_1,b_2,b_3)$
- $H_\gamma : (x_0,y_0,y_1,x_1) \rightarrow (b_0,b_1,b_2,b_3)$
- $H_\delta : (y_0,x_0,x_1,y_1) \rightarrow (b_0,b_1,b_2,b_3)$
- $H_8 : (y_0,x_0,y_1,x_1) \rightarrow (b_0,b_1,b_2,b_3)$
- $H_\phi : (x_0,y_0,x_1,y_1) \rightarrow (b_0,b_1,b_2,b_3)$

16. Procédé de codage selon l'une quelconque des revendications 14 et 15 et la revendication 10, **caractérisé en ce qu'**il met en oeuvre les sections poinçonnées suivantes :

- $H^g: (*,*,x_0,x_1) \rightarrow (*,*, b_2,b_3)$
- $H^d: (x_0,x_1,*,*) \rightarrow (b_0,b_1,*,*)$

17. Procédé de codage selon l'une quelconque des revendications des 14 à 16 et la revendication 11, **caractérisé en ce qu'**il comprend trois ensembles de codage recevant chacun 12 bits de codage via respectivement une permutation identité, une permutation à décalage cyclique de 4 bits et une permutation à décalage cyclique de 8 bits.

**18.** Procédé de codage selon la revendication 17, **caractérisé en ce que** lesdits ensembles de codage sont organisés de façon à produire un code de Golay [24, 12, 8].

**19.** Procédé de codage selon l'une quelconque des revendications 1 à 12, **caractérisé en ce que** lesdits vecteurs sont constitués de mots de base pouvant prendre 4 valeurs.

**20.** Procédé de codage selon la revendication 19, **caractérisé en ce que** ledit code élémentaire est un code de Nordstrom-Robinson de paramètres [8, 4, 6].

**21.** Procédé de codage selon l'une quelconque des revendications 1 à 12, **caractérisé en ce que** lesdits vecteurs sont constitués de mots de base pouvant prendre 8 valeurs.

**22.** Procédé de codage selon la revendication 21, **caractérisé en ce que** ledit code élémentaire est un code de Nordatrom-Robinson N16.

**23.** Procédé de codage selon l'une quelconque des revendications 1 à 22, **caractérisé en ce qu'**il est du type « turbo-code ».

**24.** Dispositif de codage correcteur d'erreur, **caractérisé en ce qu'**il comprend au moins deux modules de codage correspondant à au moins deux sections distinctes d'un code élémentaire prédéterminé, associant à un vecteur d'état de départ (s0, s1) un vecteur d'état d'arrivée (s2, s3), en fonction d'un vecteur d'étiquettes de branches (b0, b1, b2, b3), ledit vecteur d'état de départ, ledit vecteur d'état d'arrivée, et ledit vecteur d'étiquettes de branches définissant un mot de code élémentaire,
deux sections dudit code élémentaire étant distinctes si :

- les ordres des éléments du vecteur d'étiquettes de branches, dans ledit mot de code élémentaire de chacune des deux sections, sont différents ; et/ou
- les rôles, à savoir entrée ou sortie de ladite section, d'au moins un des éléments du vecteur d'étiquettes de branches, sont différents.

**25.** Procédé de décodage de données codées selon le procédé de codage selon l'une quelconque des revendications 1 à 23, **caractérisé en ce qu'**il met en oeuvre au moins deux sections distinctes d'un code élémentaire prédéterminé, associant à un vecteur d'état de départ (s0, s1) un vecteur d'état d'arrivée (s2, s3), en fonction d'un vecteur d'étiquettes de branches (b0, b1, b2, b3),
ledit vecteur d'état de départ, ledit vecteur d'état d'arrivée, et ledit vecteur d'étiquettes de branches définissant un mot de code élémentaire,
deux sections dudit code élémentaire étant distinctes si :

- les ordres des éléments du vecteur d'étiquettes de branches, dans ledit mot de code élémentaire de chacune des deux sections, sont différents ; et/ou
- les rôles, à savoir entrée ou sortie de ladite section, d'au moins un des éléments du vecteur d'étiquettes de branches, sont différents.

**26.** Procédé de décodage selon la revendication 25, **caractérisé en ce qu'**il est itératif.

**27.** Procédé de décodage selon la revendication 26, **caractérisé en ce qu'**il met en oeuvre, à chacune des itérations, une étape de calcul des probabilités a posteriori sur des métriques associés à au moins un treillis défini à l'aide desdites sections de code élémentaire, et **en ce qu'**il interrompt lesdites itérations lorsqu'un résultat stable est obtenu et/ou après un nombre prédéterminé d'itérations.

**28.** Dispositif de décodage de données codées à l'aide du procédé de codage selon l'une quelconque des revendications 1 à 23, **caractérisé en ce qu'**il comprend au moins deux modules de décodage correspondant à au moins deux sections distinctes d'un code élémentaire prédéterminé, associant à un vecteur d'état de départ (s0, s1) un vecteur d'état d'arrivée (s2, s3), en fonction d'un vecteur d'étiquettes de branches (b0, b1, b2, b3),
ledit vecteur d'état de départ, ledit vecteur d'état d'arrivée, et ledit vecteur d'étiquettes de branches définissant un mot de code élémentaire,

deux sections dudit code élémentaire étant distinctes si :

- les ordres des éléments du vecteur d'étiquettes de branches, dans ledit mot de code élémentaire de chacune des deux sections, sont différents ; et/ou
- les rôles, à savoir entrée ou sortie de ladite section, d'au moins un des éléments du vecteur d'étiquettes de branches, sont différents.

**Claims**

1. Error correcting coding method, **characterized in that** it implements at least two distinct sections of a predetermined elementary code, associating an arrival state vector (s2, s3) with starting state vector (s0, s1) according to a branch label vector (b0, b1, b2, b3),
said starting state vector, said arrival state vector and said branch label vector defining an elementary code word, two sections of said elementary code being distinct if:

- the orders of the elements of the branch label vector, in said elementary code word of each of the two sections, are different; and/or
- the roles, namely input or output of said section, of at least one of the elements of the branch label vector are different.

2. Coding method according to Claim 1, **characterized in that** the code words of said elementary code have been partitioned into four packets (s0, s1), (s2, s3), (b0, b1), (b2, b3) such that each code word, apart from the zero code word, comprises at least three packets out of four that are on, a packet being on when it comprises at least one bit set to 1.

3. Coding method according to either of Claims 1 and 2, **characterized in that** said elementary code sections are associated in sequence so as to form at least one coding trellis.

4. Coding method according to Claim 3, **characterized in that** said trellis or trellises are cyclic.

5. Coding method according to either of Claims 3 and 4, **characterized in that** it comprises two trellises, in which the source data to be coded are entered in different orders.

6. Coding method according to either of Claims 4 and 5, **characterized in that** the coding result retained is the one that has an arrival state identical to its starting state, out of all the possible starting states for one of said elementary code sections, selected as started section.

7. Coding method according to Claim 6, **characterized in that** said coding result is the set of information and redundancy elements delivered by said trellis or trellises.

8. Coding method according to Claim 7, **characterized in that** puncturing is applied on said elements forming the coding result.

9. Coding method according to any one of Claims 1 to 8, **characterized in that** at least one of said sections is punctured.

10. Coding method according to Claim 9, **characterized in that** it implements at least one punctured section on the left and at least one punctured section on the right.

11. Coding method according to any one of Claims 3 to 10, **characterized in that** said trellis or trellises are duplicated at least once, to have at least two coding sets interconnected via permutation means.

12. Coding method according to Claim 11, **characterized in that** the data to be coded are transferred to each of said coding sets with a shift.

13. Coding method according to any one of Claims 1 to 12, **characterized in that** said vectors consist of binary elements.

14. Coding method according to Claim 13, **characterized in that** said elementary code is a Hamming code [8, 4, 4].

**15.** Coding method according to Claim 14, **characterized in that** it implements the following input $(x_0, x_1)$ and output $(y_0, y_1)$ sections $H_\alpha$ to $H_\phi$:

- $H_\alpha: (y_0,y_1,x_0,x_1) \rightarrow (b_0,b_1,b_2,b_3)$
- $H_\beta: (x_0,x_1,y_0,y_1) \rightarrow (b_0,b_1,b_2,b_3)$
- $H_\gamma: (x_0,y_0,y_1,x_1) \rightarrow (b_0,b_1,b_2,b_3)$
- $H_\delta: (y_0,x_0,x_1,y_1) \rightarrow (b_0,b_1,b_2,b_3)$
- $H_\varepsilon: (y_0,x_0,y_1,x_1) \rightarrow (b_0,b_1,b_2,b_3)$
- $H_\o: (x_0,y_0,x_1,y_1) \rightarrow (b_0,b_1,b_2,b_3)$

**16.** Coding method according to either of Claims 14 and 15 and Claim 10, **characterized in that** it implements the following punctured sections:

- $H^x: (*,*,x_0,x_1) \rightarrow (*,*,b_2,b_3)$
- $H^d: (x_0,x_1,*,*) \rightarrow (b_0,b_1,*,*)$

**17.** Coding method according to any one of Claims 14 to 16 and Claim 11, **characterized in that** it comprises three coding sets, each receiving 12 coding bits respectively via an identity permutation, a 4-bit cyclic shift permutation and a 8-bit cyclic shift permutation.

**18.** Coding method according to Claim 17, **characterized in that** said coding sets are organized so as to produce a Golay code [24, 12, 8].

**19.** Coding method according to any one of Claims 1 to 12, **characterized in that** said vectors consist of basic words that can take four values.

**20.** Coding method according to Claim 19, **characterized in that** said elementary code is a Nordstrom-Robinson parameter code [8, 4, 6].

**21.** Coding method according to any one of Claims 1 to 12, **characterized in that** said vectors consist of basic words that can take eight values.

**22.** Coding method according to Claim 21, **characterized in that** said elementary code is an N16 Nordstrom-Robinson code.

**23.** Coding method according to any one of Claims 1 to 22, **characterized in that** it is of the "turbo-code" type.

**24.** Error correcting coding device, **characterized in that** it comprises at least two coding modules corresponding to at least two distinct sections of a predetermined elementary code, associating an arrival state vector (s2, s3) with a starting state vector (s0, s1) according to a branch label vector (b0, b1, b2, b3), said starting state vector, said arrival state vector and said branch label vector defining a elementary code word, two sections of said elementary code being distinct if:

- the orders of the elements of the branch label vector, in said elementary code word of each of the two sections, are different; and/or
- the roles, namely input or output of said section, of at least one of the elements of the branch label vector are different.

**25.** Method of decoding data coded according to the coding method according to any one of Claims 1 to 23, **characterized in that** it implements at least two distinct sections of a predetermined elementary code, associating an arrival state vector (s2, s3) with an starting state vector (s0, s1) according to a branch label vector (b0, b1, b2, b3), said starting state vector, said arrival state vector and said branch label vector defining a elementary code word, two sections of said elementary code being distinct if:

- the orders of the elements of the branch label vector, in said elementary code word of each of the two sections, are different; and/or
- the roles, namely input or output of said section, of at least one of the elements of the branch label vector are different.

**26.** Decoding method according to Claim 25, **characterized in that** it is iterative.

**27.** Decoding method according to Claim 26, **characterized in that** it implements, on each of the iterations, a step for computing a posteriori probabilities on metrics associated with at least one trellis defined using said elementary code sections, and **in that** it stops said iterations when a stable result is obtained and/or after a predetermined number of iterations.

**28.** Device for decoding data coded using a coding method according to any one of Claims 1 to 23, **characterized in that** it comprises at least two decoding modules corresponding to at least two distinct sections of a predetermined elementary code, associating an arrival state vector (s2, s3) with an starting state vector (s0, s1) according to a branch label vector (b0, b1, b2, b3), said starting state vector, said arrival state vector and said branch label vector defining an elementary code word,
two sections of said elementary code being distinct if:

- the orders of the elements of the branch label vector, in said elementary code word of each of the two sections, are different; and/or
- the roles, namely input or output of said section, of at least one of the elements of the branch label vector are different.

**Patentansprüche**

**1.** Fehlerkorrekturcodierverfahren, **dadurch gekennzeichnet, dass** es mindestens zwei unterschiedliche Sektionen eines vorbestimmten Elementarcodes verwendet, wobei es einem Ausgangszustandsvektor (s0, s1) einen Ankunftszustandsvektor (s2, s3) in Abhängigkeit von einem Zweigkennungsvektor (b0, b1, b2, b3) zuordnet,
wobei der Ausgangszustandsvektor, der Ankunftszustandsvektor und der Zweigkennungsvektor ein Elementarcodewort definieren,
wobei zwei Sektionen des Elementarcodes sich unterscheiden, wenn:

- die Reihenfolgen der Elemente des Zweigkennungsvektors in dem Elementarcodewort jeder der zwei Sektionen unterschiedlich sind; und/oder
- die Aufgaben, d.h. Eingang oder Ausgang der Sektion, mindestens eines der Elemente des Zweigkennungsvektors unterschiedlich sind.

**2.** Codierverfahren nach Anspruch 1, **dadurch gekennzeichnet, dass** die Codewörter des Elementarcodes eine derartige Aufteilung in vier Pakete (s0, s1), (s2, s3), (b0, b1), (b2, b3) erfahren haben, dass jedes Codewort mit Ausnahme des Codeworts Null mindestens drei eingeschaltete von vier Paketen enthält, wobei ein Paket als eingeschaltet bezeichnet wird, wenn es mindestens ein Bit mit dem Wert 1 enthält.

**3.** Codierverfahren nach einem der Ansprüche 1 und 2, **dadurch gekennzeichnet, dass** die Elementarcode-Sektionen in einer Sequenz angeordnet sind, um mindestens ein Codiergitter zu bilden.

**4.** Codierverfahren nach Anspruch 3, **dadurch gekennzeichnet, dass** das oder die Gitter zyklisch sind.

**5.** Codierverfahren nach einem der Ansprüche 3 und 4, **dadurch gekennzeichnet, dass** es zwei Gitter aufweist, in die die zu codierenden Quellendaten in unterschiedlichen Reihenfolgen eingefügt werden.

**6.** Codierverfahren nach einem der Ansprüche 4 und 5, **dadurch gekennzeichnet, dass** man als Codierergebnis dasjenige behält, das einen Ankunftszustand gleich seinem Ausgangszustand aufweist, unter allen möglichen Ausgangszuständen für eine der Elementarcode-Sektionen, die als Ausgangssektion gewählt wird.

**7.** Codierverfahren nach Anspruch 6, **dadurch gekennzeichnet, dass** das Codierergebnis die Gesamtheit der Informations- und Redundanzelemente ist, die von dem oder den Gittern geliefert werden.

**8.** Codierverfahren nach Anspruch 7, **dadurch gekennzeichnet, dass** es eine Lochung an den das Codierergebnis bildenden Elementen anwendet.

**9.** Codierverfahren nach einem der Ansprüche 1 bis 8, **dadurch gekennzeichnet, dass** mindestens eine der Sektionen gelocht ist.

10. Codierverfahren nach Anspruch 9, **dadurch gekennzeichnet, dass** es mindestens eine links gelochte Sektion und eine rechts gelochte Sektion verwendet.

11. Codierverfahren nach einem der Ansprüche 3 bis 10, **dadurch gekennzeichnet, dass** das oder die Gitter mindestens einmal gedoppelt werden, um über mindestens zwei Codiereinheiten zu verfügen, die über Permutationsmittel miteinander verbunden sind.

12. Codierverfahren nach Anspruch 11, **dadurch gekennzeichnet, dass** die zu codierenden Daten an jede der Codiereinheiten versetzt übertragen werden.

13. Codierverfahren nach einem der Ansprüche 1 bis 12, **dadurch gekennzeichnet, dass** die Vektoren aus Binärelementen bestehen.

14. Codierverfahren nach Anspruch 13, **dadurch gekennzeichnet, dass** der Elementarcode ein Hamming-Code [8, 4, 4] ist.

15. Codierverfahren nach Anspruch 14, **dadurch gekennzeichnet, dass** es die folgenden Sektionen $H_\alpha$ bis $H_\phi$ des Eingangs $(x_0, x_1)$ und Ausgangs $(y_0, y_1)$ verwendet:

- $H_\alpha : (y_0,y_1,x_0,x_1) \rightarrow (b_0,b_1,b_2,b_3)$
- $H_\beta : (x_0,x_1,y_0,y_1) \rightarrow (b_0,b_1,b_2,b_3)$
- $H_\gamma : (x_0,y_0,y_1,x_1) \rightarrow (b_0,b_1,b_2,b_3)$
- $H_\delta : (y_0,x_0,x_1,y_1) \rightarrow (b_0,b_1,b_2,b_3)$
- $H_\varepsilon : (y_0,x_0,y_1,x_1) \rightarrow (b_0,b_1,b_2,b_3)$
- $H_\phi : (x_0,y_0,x_1,y_1) \rightarrow (b_0,b_1,b_2,b_3)$

16. Codierverfahren nach einem der Ansprüche 14 und 15 und Anspruch 10, **dadurch gekennzeichnet, dass** es die folgenden gelochten Sektionen anwendet:

- $H^x : (*,* ,x_0, x_1) \rightarrow (*,*,b_2,b_3)$
- $H^d : (x_0, x_1*,*) \rightarrow (b_0, b_1,*,*)$

17. Codierverfahren nach einem der Ansprüche 4 bis 16 und Anspruch 11, **dadurch gekennzeichnet, dass** es drei Codiereinheiten aufweist, die je 12 Codierbits über eine Identitätspermutation, eine Permutation mit zyklischer Verschiebung von 4 Bits bzw. eine Permutation mit zyklischer Verschiebung von 8 Bits empfangen.

18. Codierverfahren nach Anspruch 17, **dadurch gekennzeichnet, dass** die Codiereinheiten so organisiert sind, dass sie einen Golay-Code [24, 12, 8] erzeugen.

19. Codierverfahren nach einem der Ansprüche 1 bis 12, **dadurch gekennzeichnet, dass** die Vektoren aus Basiswörtern bestehen, die 4 Werte annehmen können.

20. Codierverfahren nach Anspruch 19, **dadurch gekennzeichnet, dass** der Elementarcode ein Nordstrom-Robinson-Parametercode [8, 4, 6] ist.

21. Codierverfahren nach einem der Ansprüche 1 bis 12, **dadurch gekennzeichnet, dass** die Vektoren aus Basiswörtern bestehen, die 8 Werte annehmen können.

22. Codierverfahren nach Anspruch 21, **dadurch gekennzeichnet, dass** der Elementarcode ein Nordstrom-Robinson-Code N16 ist.

23. Codierverfahren nach einem der Ansprüche 1 bis 22, **dadurch gekennzeichnet, dass** es vom Typ "Turbocode" ist.

24. Fehlerkorrekturcodiervorrichtung, **dadurch gekennzeichnet, dass** sie mindestens zwei Codiermodule aufweist, die mindestens zwei unterschiedlichen Sektionen eines vorbestimmten Elementarcodes entsprechen, wobei einem Ausgangszustandsvektor (s0, s1) ein Ankunftszustandsvektor (s2, s3) in Abhängigkeit von einem Zweigkennungsvektor (b0, b1, b2, b3) zugeordnet wird,

wobei der Ausgangszustandsvektor, der Ankunftszustandsvektor und der Zweigkennungsvektor ein Elementarcodewort definieren,

wobei zwei Sektionen des Elementarcodes sich unterscheiden, wenn:

- die Reihenfolgen der Elemente des Zweigkennungsvektors in dem Elementarcodewort jeder der zwei Sektionen unterschiedlich sind; und/oder
- die Aufgaben, d.h. Eingang oder Ausgang der Sektion, mindestens eines der Elemente des Zweigkennungsvektors, unterschiedlich sind.

25. Decodierverfahren von Daten, die gemäß dem Codierverfahren nach einem der Ansprüche 1 bis 23 codiert sind, **dadurch gekennzeichnet, dass** es mindestens zwei unterschiedliche Sektionen eines vorbestimmten Elementarcodes verwendet, wobei einem Ausgangszustandsvektor (s0, s1) ein Ankunftszustandsvektor (s2, s3) in Abhängigkeit von einem Zweigkennungsvektor (b0, b1, b2, b3) zugeordnet wird,

wobei der Ausgangszustandsvektor, der Ankunftszustandsvektor und der Zweigkennungsvektor ein Elementarcodewort definieren,

wobei zwei Sektionen des Elementarcodes sich unterscheiden, wenn:

- die Reihenfolgen der Elemente des Zweigkennungsvektors in dem Elementarcodewort jeder der zwei Sektionen unterschiedlich sind; und/oder
- die Aufgaben, d.h. Eingang oder Ausgang der Sektion, mindestens eines der Elemente des Zweigkennungsvektors, unterschiedlich sind.

26. Decodierverfahren nach Anspruch 25, **dadurch gekennzeichnet, dass** es iterativ ist.

27. Decodierverfahren nach Anspruch 26, **dadurch gekennzeichnet, dass** es bei jeder der Iterationen einen Schritt der Berechnung der a-posteriori-Wahrscheinlichkeiten an Metriken anwendet, die mindestens einem Gitter zugeordnet sind, das mit Hilfe der Elementarcode-Sektionen definiert wird, und dass es die Iterationen unterbricht, wenn ein stabiles Ergebnis erhalten wird und/oder nach einer vorbestimmten Anzahl von Iterationen.

28. Decodiervorrichtung von Daten, die mit Hilfe des Codierverfahrens nach einem der Ansprüche 1 bis 23 codiert wurden, **dadurch gekennzeichnet, dass** sie mindestens zwei Decodiermodule aufweist, die mindestens zwei unterschiedliche Sektionen eines vorbestimmten Elementarcodes entsprechen, wobei einem Ausgangszustandsvektor (s0, s1) ein Ankunftszustandsvektor (s2, s3) in Abhängigkeit von einem Zweigkennungsvektor (b0, b1, b2, b3) zugeordnet wird,

wobei der Ausgangszustandsvektor, der Ankunftszustandsvektor und der Zweigkennungsvektor ein Elementarcodewort definieren,

wobei zwei Sektionen des Elementarcodes sich unterscheiden, wenn:

- die Reihenfolgen der Elemente des Zweigkennungsvektors in dem Elementarcodewort jeder der zwei Sektionen unterschiedlich sind; und/oder
- die Aufgaben, d.h. Eingang oder Ausgang der Sektion, mindestens eines der Elemente des Zweigkennungsvektors, unterschiedlich sind.

Etiquettes de branches (b0,b1,b2,b3)

0000,1110,1011,0101

1101,0011,0110,1000

0111,1001,1100,0010

1010,0100,0001,1111

( S0,S1 )          ( S2,S3 )

## Fig. 1

## Fig. 2

Fig. 3

Fig. 4

Courbes de taux d'erreur binaire d'un code [300,100] sur canal gaussien
pour différents nombre d'iterations

Fig. 5a

Courbes de taux d'erreur binaire d'un code [600,200] sur canal gaussien
pour differents nombres d'iterations

Fig. 5b

Courbes de taux d'erreur binaire d'un code [160,80] sur canal gaussien
pour differents nombres d'iterations

Fig. 5c

Courbes de taux d'erreur binaire d'un code [400,200] sur canal gaussien
pour differents nombres d'iterations

Fig. 5d

Courbes de decodage d'un code [400,200] sous forme CT(3,1) et TC(21,37) pour 18 iterations
et sous forme de concatenation de treillis a 4 etats pour 15 iterations (canal gaussien)

## Fig. 5e

Courbes de taux d'erreur binaire d'un code [2960,1480] sur canal gaussien
pour differents nombres d'iterations

## Fig. 6

20

b0                                            b1

2                         2

4                         4

s0,s1                                          s2,s3

2                         2

b2                                            b3

**Fig. 7**

b0                                            b1

3                         3

6                         6

s0,s1                                          s2,s3

3                         3

b2                                            b3

**Fig. 8**